# EUROPÄISCHE PATENTSCHRIFT

(11) **EP 2 139 306 B1**
(45) Veröffentlichungstag und Bekanntmachung des Hinweises auf die Patenterteilung: **10.01.2018**
(21) Anmeldenummer: 09100346.7
(22) Anmeldetag: 25.06.2009
(51) Int. Cl.: H05K 7/14

(54) **Gehäuse für Leiterplatte**
Housing for circuit board
Boîtier pour plaques conductrices

(30) Priorität: 27.06.2008 DE 202008008516 U
(43) Veröffentlichungstag der Anmeldung: 30.12.2009
(73) Patentinhaber: Inter Control Hermann Köhler GmbH & Co. KG, 90411 Nürnberg (DE)
(72) Erfinder: Wolf, Roland, 91217 Hersbruck (DE); Olesniewicz, Miroslaw, 90471 Nürnberg (DE)
(74) Vertreter: Stippl, Hubert

(56) Entgegenhaltungen:
- DE-A1-102004 015 517
- US-A- 4 791 531

## Beschreibung

Die vorliegende Erfindung bezieht sich auf ein Gehäuse für wenigstens eine Leiterplatte.

Gehäuse zur Aufnahme von Leiterplatten sind aus dem Stand der Technik beispielsweise aus der DE 20215 425 U1 bekannt, wobei das bekannte Gehäuse für mindestens eine bestückte elektronische Leiterplatte ausgelegt ist und Abstandshaltemittel umfasst, die die Leiterplatte gegenüber dem Gehäuseboden auf Abstand halten sowie außerdem Fixierungsmittel für die Leiterplatte in dem Gehäuse umfasst, und wobei sowohl die Abstandshaltemittel als auch die Fixierungsmittel durch eine entsprechende Formgebung des Gehäuses realisiert sind indem die beiden gegenüberliegenden Seitenwände von dem Gehäuseboden ausgehend divergierend nach oben verlaufen, und zwar derart, dass sie mit Abstand über dem Gehäuseboden eine der betreffenden Abmessung der Leiterplatte entsprechende Distanz zueinander haben und auf diese Weise die Auflagebereiche für die Leiterplatte bilden.

Das vorstehende bekannte Gehäuse weist zum einen Abstandshaltemittel auf, die die Leiterplatte gegenüber dem Gehäuseboden auf Abstand halten sowie Fixierungsmittel für die Leiterplatte, wobei sowohl die Abstandshaltemittel als auch die Fixierungsmittel allein durch eine entsprechende Formgebung des Gehäuses realisiert sind.

Das vorstehend genannte bekannte Gehäuse umfasst außerdem eine Abdeckung, die einstückig mit Befestigungsfüßen des Gehäuses ausgebildet ist. Außerdem sind die Abstandshaltemittel der Leiterplatte vom Boden des Gehäuses mittels abgewinkelten seitlichen Wänden des Gehäuses bereitgestellt, wodurch die Leiterplatte zwar vom Boden beabstandet ist aber keinen sicheren Halt findet und hierbei vorgegeben durch die Geometrie und die Abmessungen des Gehäuses außerdem lediglich gleichartig ausgebildete Leiterplatten in dem Gehäuse angeordnet werden können.

Ein Gehäuse gemäß dem Oberbegriff des Anspruchs 1 ist aus der DE 10 2004 015 517 A1 bekannt. Bei diesem bekannten Gehäuse wird eine Leiterplatte auf einer Wandseite des Gehäuses in eine Nut eingesetzt und auf der gegenüberliegenden Wandseite auf einer Absatzkante gelagert.

Die US 4,791,531 offenbart ein extrudiertes U-förmiges Gehäuse, bei dem Leiterplatten in beidseits vorgesehene Nuten von der Seite eingeschoben werden müssen.

Aufgabe der vorliegenden Erfindung ist daher eine einfache und kostengünstige Lösung zur Anordnung mindestens einer Leiterplatte in einem Gehäuse anzugeben, das auf einfache Weise flexibel und auch variabel bereitgestellt und montiert werden kann.

Die Aufgabe wird mit den Merkmalen des unabhängigen Anspruchs 1 gelöst. Vorteilhafte Ausführungen sind in den Merkmalen der Unteransprüche und/oder der nachfolgenden Beschreibung erwähnt, die von schematischen Zeichnungen begleitet ist. Hierzu zeigt:
- Fig. 1: eine schematische perspektivische Darstellung eines erfindungsgemäßen Gehäuses für eine Leiterplatte;
- Fig. 2: eine schematische perspektivische Darstellung eines erfindungsgemäßen Gehäuses für eine Leiterplatte nach einer weiteren Ausführung;
- Fig. 3: einen vergrößerten Ausschnitt des Gehäuses von Fig. 2;
- Fig. 4: eine perspektivische Darstellung des Gehäuses von Fig. 2 und 3 von hinten;
- Fig. 5A: einen Schnitt durch die Leiterplatte von Fig. 1 entlang der Linie A-A von Fig. 1 und Fig. 5B einen vergrößerten Ausschnitt von Fig. 5A;
- Fig. 6: das Gehäuse von Fig. 2 mit einer Hutschiene; die Hutschiene ist nicht Gegenstand der Erfindung;
- Fig. 7: eine Seitenansicht des Gehäuses von Fig. 6 mit der Hutschiene.

Ein Gehäuse für eine Leiterplatte nach einer Ausführung der vorliegenden Erfindung umfasst insbesondere einen länglichen einstückig ausgebildeten U - förmigen Gehäusegrundkörper mit einem Gehäuseboden und einer ersten und einer zweiten Wand und mit zwei seitlichen Wänden, die an dem Gehäusegrundkörper befestigt sind, wobei der Gehäusegrundkörper erfindungsgemäß aus Strangpreßprofil bereitgestellt ist, und der Gehäusegrundkörper mit den beiden an ihm befestigten seitlichen Wänden ein nach oben offenes kastenförmiges Gehäuse bildet, das derart ausgebildet ist, dass wenigstens eine Leiterplatte von oben in das Gehäuse einsetzbar und in dem Gehäuse fixierbar ist, wobei die oberste der Leiterplatten mit ihrer bestückten Seite nach unten angeordnet ist und ihre andere Seite das Gehäuse oben abschließt.

Ein erfindungsgemäßes Gehäuse nach der Ausführung der vorliegenden Erfindung ist besonders vorteilhaft, nachdem es einfach montierbar ist und auch auf einfache Weise hergestellt werden kann insbesondere auch in verschiedenen Abmessungen für verschieden dimensionierte Leiterplatten, insbesondere aufgrund der erfindungsgemäßen Ausbildung des Gehäusegrundkörpers als Strangpreßprofil, dessen Länge auf einfache Weise variiert werden kann, um alternative Gerätevarianten zu erzeugen.

Ein erfindungsgemäßes Gehäuse für wenigstens eine Leiterplatte nach einer weiteren Ausführung umfasst insbesondere einen länglichen einstückig ausgebildeten U - förmigen Gehäusegrundkörper mit einem Gehäuseboden und einer ersten und zweiten Wand, und mit zwei seitlichen Wänden, die an einem Gehäusegrundkörper befestigt sind, wobei der Gehäusegrundkörper mit den beiden seitlichen Wänden ein nach oben offenes kastenförmiges Gehäuse bildet, das derart ausgebildet ist, dass wenigstens eine Leiterplatte von oben in das Gehäuse einsetzbar und dem Gehäuse fixierbar ist, wobei die oberste der Leiterplatten mit ihrer bestückten Seite nach unten angeordnet ist und ihre andere Seite das Gehäuse nach oben abschließt und auf der nach oben freiliegenden Seite der Leiterplatte Anschlußbuchsen für Steckverbindungen mit Kabeln angeordnet sind. Das vorstehende erfindungsgemäße Gehäuse umfasst außerdem einen mit den beiden seitlichen Wänden einstückigen Befestigungsbügel, der sich oberhalb der das Gehäuse oben abschließenden Leiterplatte von einer seitlichen Wand zu der anderen seitlichen Wand erstreckt, wobei der Befestigungsbügel derart ausgebildet ist, dass Klemmbefestigungen oder Kabelbinder für mit dem Anschlußbuchsen verbundene Kabel für Zugentlastungen der Kabel an dem Befestigungsbügel vorsehbar sind.

Bei einer weiteren Ausführung ist die einstückige Ausbildung des Befestigungsbügels für Klemmvorrichtungen oder Kabelbinder für Zugentlastungen von Kabeln mit den beiden seitlichen Wänden des Gehäuses besonders vorteilhaft, da der Befestigungsbügel mit den beiden seitlichen Wänden aus einem Metallblech auf einfache Weise gestanzt werden kann, und wonach das Metallblech zur Bereitstellung der seitlichen Wände und des Befestigungsbügels auf einfache Weise abgewinkelt werden kann.

Die vorstehend genannten Ausführungen sind auch besonders vorteilhaft, weil auf geeignete Weise Material gespart wird, nachdem die oben angeordnete Leiterplatte mit ihrer Bestückungsseite nach innen und unten ins Gehäuse angeordnet ist, und dabei mit ihrer nach oben angeordneten Seite zugleich als Abdeckung des Gehäuses fungiert, was Material- und Montageaufwand spart.

Die vorliegende Erfindung wird nachfolgend ohne jede Beschränkung anhand von schematischen Zeichnungen detailliert beschrieben.

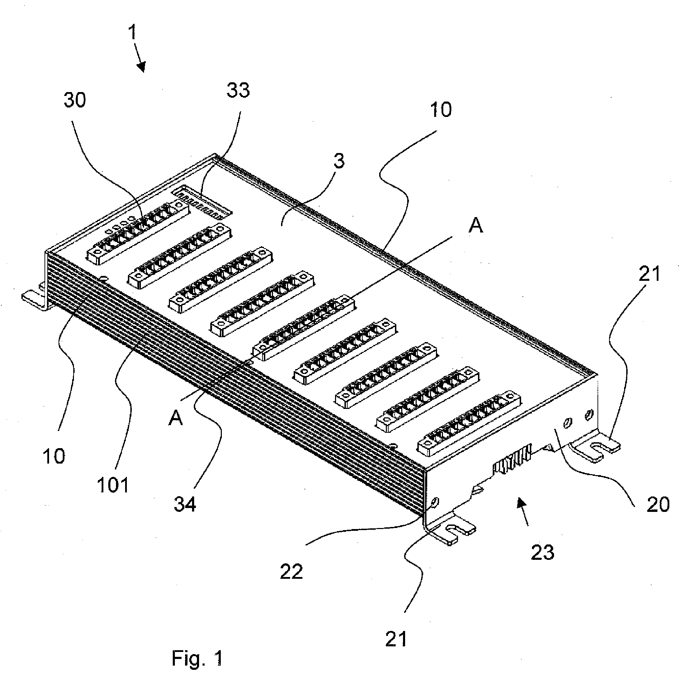

Fig. 1 zeigt eine schematische Darstellung eines Gehäuses 1 für eine Leiterplatte 3, 3' nach einer ersten Ausführung der vorliegenden Erfindung in perspektivischer Darstellung mit einem U - förmigen Gehäusegrundkörper 10, der einen Boden mit zwei gegenüberliegenden Wänden 101, 102 umfasst, wobei an dem Gehäusegrundkörper 10 außerdem seitliche Wände 20 befestigt sind, die das Gehäuse 1 von der Seite abschließen. An den seitlichen Wänden 20 sind geeigneterweise Füße 21 ausgebildet, die entsprechend abgewinkelt sind, und die es gestatten, das Gehäuse 1 auf einfache Weise auf einer Montagefläche zu befestigen. Erfindungsgemäß wird die Abdeckung des Gehäuses 1 mittels einer nicht bestückten Grundoberfläche einer Leiterplatte 3 bereitgestellt, die in dem Gehäuse 1 angeordnet ist, wobei die Leiterplatte 3 geeigneterweise auch Anschlußbuchsen 30 für die Verbindung von Kabeln umfassen kann, und außerdem auch ein Fenster 33 zur Ansicht in das Innere des Gehäuses 1 umfassen kann. Zur Befestigung der seitlichen Wände 20 an dem Grundkörper 10 umfassen die seitlichen Wände geeignete Bohrungen 22 für entsprechende Befestigungsmittel. Ebenso umfasst die obere Leiterplatte 3 Bohrungen 34 ebenfalls für geeignete Befestigungsmittel der Leiterplatte 3 an dem Gehäusegrundkörper 10.

Erfindungsgemäß ist der Gehäusegrundkörper 10 aus Strangpreßprofil und insbesondere vorteilhaft aus Aluminium-Strangpreßprofil bereitgestellt, so dass seine Länge auf einfache Weise verändert werden kann und auf ebenso einfache Weise eine Vielzahl unterschiedlicher Variationen für längere oder kürzere Leiterplatten mit mehr oder weniger Steckverbindungen oder Ausgängen mit Anschlußbuchsen bereitgestellt werden kann.

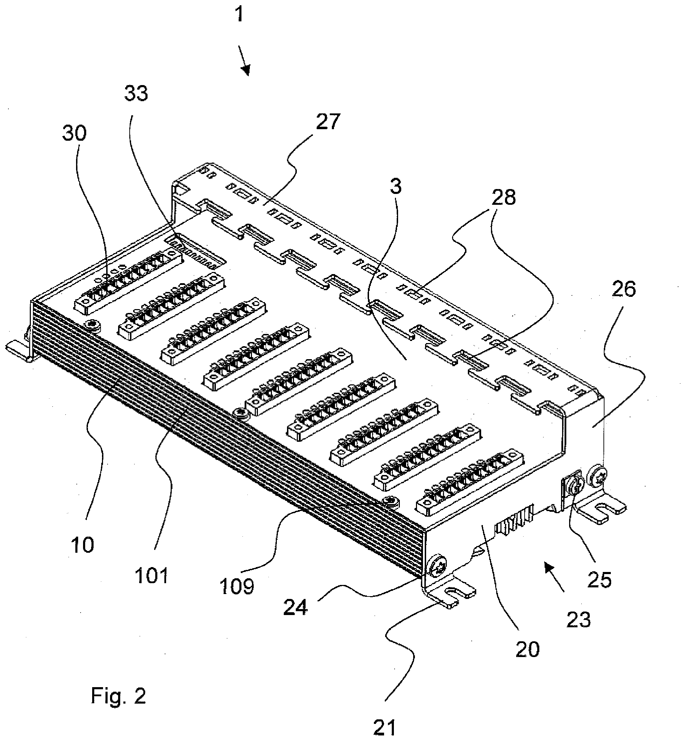

Fig. 2 zeigt eine perspektivische Darstellung eines erfindungsgemäßen Gehäuses 1 für wenigstens eine Leiterplatte 3, 3' nach einer weiteren Ausführung, die in weiten Bereichen der Ausführung von Fig. 1 entspricht, weshalb gleiche Elemente des Gehäuses 1 mit gleichen Bezugszeichen versehen sind und weshalb der Einfachheit halber auf eine weitere Beschreibung verzichtet wird.

Das Gehäuse 1 von Fig. 2 umfasst insbesondere außerdem einen Befestigungsbügel 27, der mit den seitlichen Wänden 20 einstückig ausgebildet ist, und sich ausgehend von einem nach oben vorspringenden Absatz 26 einer seitlichen Wand 20 hin zu einem entsprechend ausgebildeten zweiten vorspringenden Absatz 26 der zweiten seitlichen Wand 20 erstreckt und oberhalb und parallel zu der oberen das Gehäuse 1 abdeckenden Leiterplatte 3 mit nach oben herausragenden Anschlußbuchsen 30 für Steckverbindungen von Kabeln angeordnet ist. Der Befestigungsbügel 27 umfasst insbesondere wenigstens eine geeignete mittels Ausnehmungen 28 bereitgestellte Lochreihe zur Befestigung von Kabelbindern oder Kabelklemmen beliebiger Bauart zum Schutz von mit den Anschlußbuchsen 30 verbundenen Steckverbindungen und Kabeln und zur Zugentlastung der Kabel.

Bei einer weiteren Ausführung ist der Befestigungsbügel 27 insbesondere mit den beiden seitlichen Wänden 2 einstückig ausgebildet und geeigneterweise aus einem gemeinsamen Metallblech gestanzt, wobei die seitlichen Wände 20 mit ihren Füßen 21 auf geeignete Weise abgewinkelt sind.

Fig. 2 zeigt außerdem geeignete Befestigungsmittel 24 für die Befestigung der seitlichen Wände an dem Gehäusegrundkörper 10 und Befestigungsmittel 109 für die Leiterplatte 3, die jeweils in Bohrungen angeordnet sind, die den Bohrungen 22 und 34 des erfindungsgemäßen Gehäuses 1 nach der Ausführung von Fig. 1 entsprechen. Eine seitliche Wand 20 kann außerdem geeigneterweise einen Anschluss 25 für eine Erdung des Gehäuses 1 umfassen.

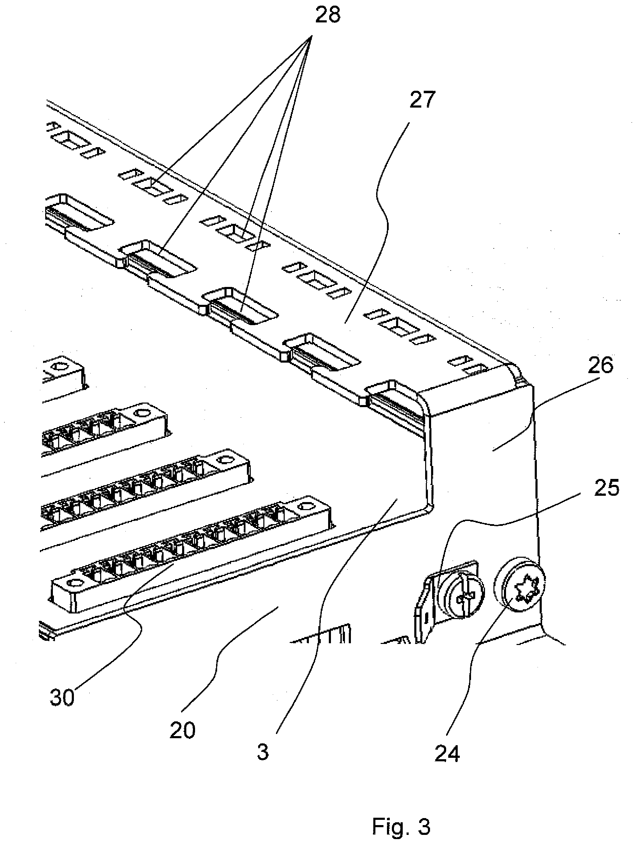

Fig. 3 zeigt eine vergrößerte perspektivische Darstellung des erfindungsgemäßen Gehäuses 1 von Fig. 1 in einer Teilansicht mit der seitlichen Wand 20, dem nach oben vorspringenden Absatz 26 und dem Befestigungsbügel 27, in dem geeigneterweise zwei mittels geeigneter Ausnehmungen 28 bereitgestellte Lochreihe vorgesehen sind, so dass eine Vielzahl unterschiedlicher Kabelbinder oder Klemmvorrichtungen an dem Befestigungsbügel 27 montierbar sind.

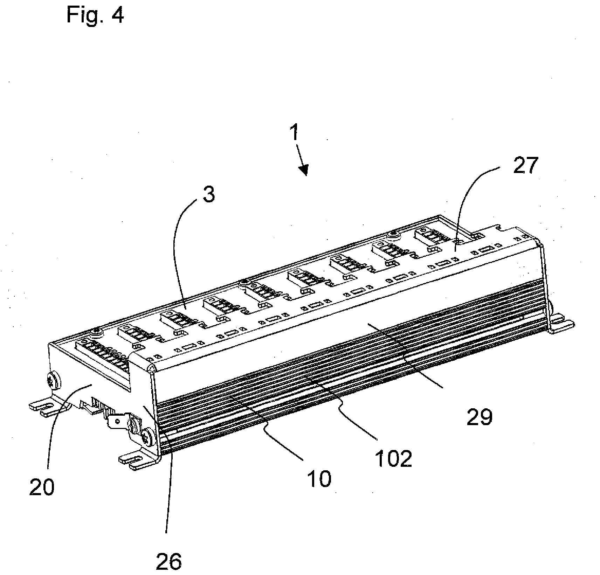

Fig. 4 zeigt eine schematische Darstellung des erfindungsgemäßen Gehäuses 1 von hinten, wobei der Einfachheit halber nur die wesentlichen Grundbauelemente des Gehäuses 1 mit Bezugszeichen versehen sind, nämlich der Gehäusegrundkörper 10 mit seiner einen Wand 102, die seitliche Wand 20 und die obere Leiterplatte 3 und der Befestigungsbügel 27, wobei an dem Befestigungsbügel 27 geeigneterweise und vorteilhaft eine Blende 29 vorgesehen ist, die nach unten zu der Wand 102 hin abgewinkelt ist und den Bereich der Klemmvorrichtungen und Anschlußbuchsen 30 zur Seite der Wand 102 hin abschirmt.

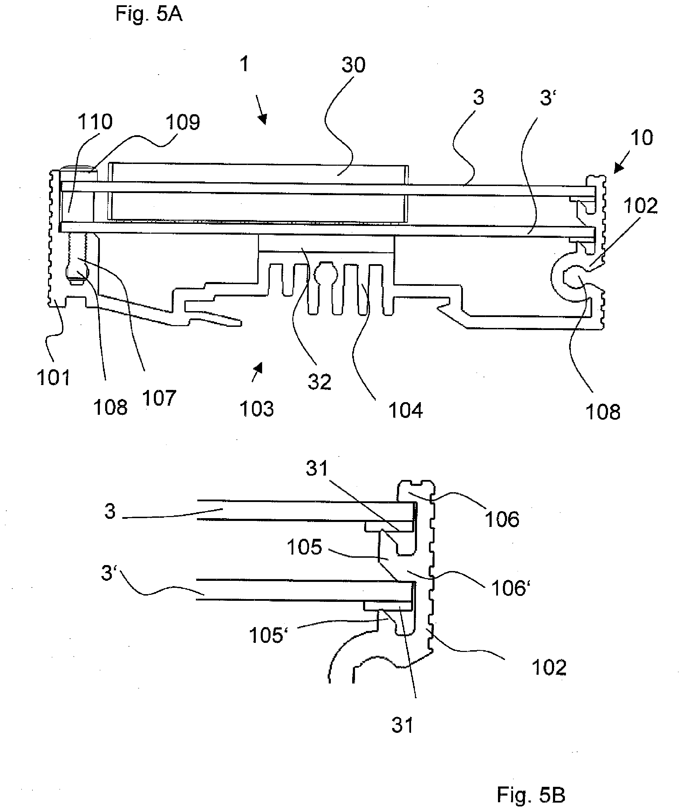

Fig. 5A zeigt einen schematischen Schnitt durch die Linie A-A von Fig. 1 mit dem Gehäuse 1 mit seinem Gehäusegrundkörper 10, der länglich ausgebildet ist und einen Gehäuseboden und zwei seitliche Wände 101, 102 umfasst, und mit zwei Leiterplatten 3, 3', die in dem Gehäuse 1 angeordnet sind, wobei geeigneterweise die obere Leiterplatte 3 das Gehäuse 1 nach oben abschließt und zugleich einen Anschluß 30 für Kabel bereitstellt.

Vorteilhaft umfasst eine der seitlichen Wände 101, 102 an ihrer Unterseite eine geeignet ausgebildete Klemmzone zur einfachen Einführung und festen Fixierung der Leiterplatten 3, 3' mit jeweils einem oberen und unteren geeignet ausgebildeten Vorsprung 106, 105; 106', 105' wobei jeweils der untere Vorsprung 105, 105' abgewinkelt ausgebildet sind, was eine einfache Montage der Leiterplatten 3, 3' in dem Gehäuse 1 ermöglicht. Die Vorsprünge 106, 105 bzw. 106', 105' sind außerdem geeigneterweise derart angeordnet, dass nach Einfuhr einer Leiterplatte 3, 3' in den zwischen den Vorsprüngen 105, 106 und 105', 106' bereitgestellten Raum in einem Winkel von oben und nach Absenkung der Leiterplatte 3, 3' in eine waagerechte Position die Leiterplatte 3, 3' zwischen den Vorsprüngen 105,106; 105', 106' sicher gehalten wird. Erfindungsgemäß wird dabei mit den jeweiligen Vorsprüngen 106, 105; 106', 105', die geeigneterweise schienenartig ausgebildet sein können, eine Klemmzone für die Leiterplatten 3, 3' bereitgestellt.

Die gegenüberliegende Wand 101 umfasst einen geeigneten Absatz zur Lagerung der unteren Leiterplatte 3', die nach Einfuhr der Leiterplatte 3' in die Klemmzone 105', 106' und nach Absenkung der Leiterplatte 3' auf dem Absatz der Wand 101 aufliegt. Der mit der Wand 101 einstückig ausgebildete Absatz zur Auflage der Leiterplatte 3' umfasst geeigneterweise senkrechte Ausnehmungen 108, die mit den Bohrungen 34 der Leiterplatte 3, 3' korrespondieren, so dass geeignete Befestigungsmittel 109, die geeigneterweise und beispielhaft Schrauben sein können, die Leiterplatte 3, 3' an dem Gehäusegrundkörper 10 fixieren können. Zur Beabstandung der oberen Leiterplatte 3 von der unteren Leiterplatte 3' ist hierfür insbesondere ein geeignetes Distanzstück 110 vorgesehen, das auf der Leiterplatte 3' aufliegt, und auf dem wiederum die obere Leiterplatte 3 aufliegt, wobei das Distanzstück 110 geeigneterweise ebenfalls von dem Befestigungsmittel 109 gehalten wird und beispielsweise und vorteilhaft hülsenartig ausgebildet sein kann.

Der Gehäusegrundkörper 10 umfasst außerdem vorteilhaft einen konturartig ausgebildeten Boden mit einer Kontur 103 und mit Kühlrippen 104, zur Ableitung oder Zufuhr von Wärme in oder aus dem Gehäuseinneren, wobei geeigneterweise im Gehäuseinneren in der Umgebung der Kühlrippe 104 ein geeignetes Wärmeleitelement 32 vorgesehen sein kann, das direkten Kontakt mit dem Boden des Gehäusegrundkörpers 10 und der unteren Leiterplatte 3' hat. Hierfür ist in den seitlichen Wänden 20 eine geeignete Kulisse 23 derart ausgebildet, dass die Kontur 103 und die Kühlrippen 104 seitlich frei liegen.

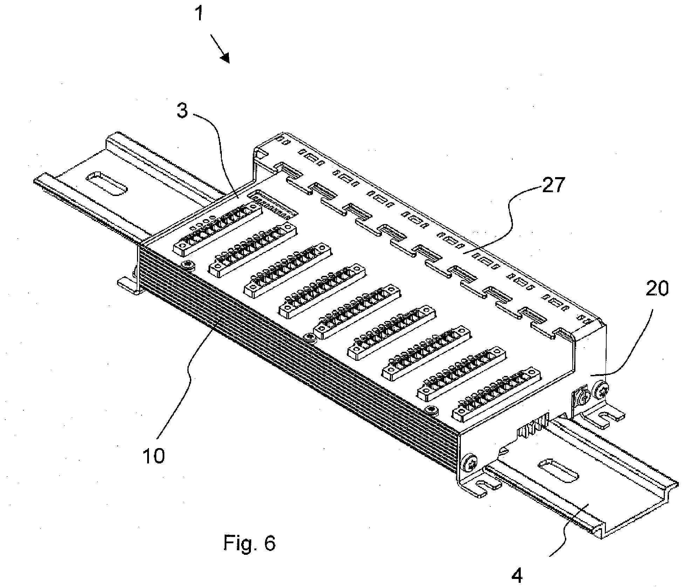

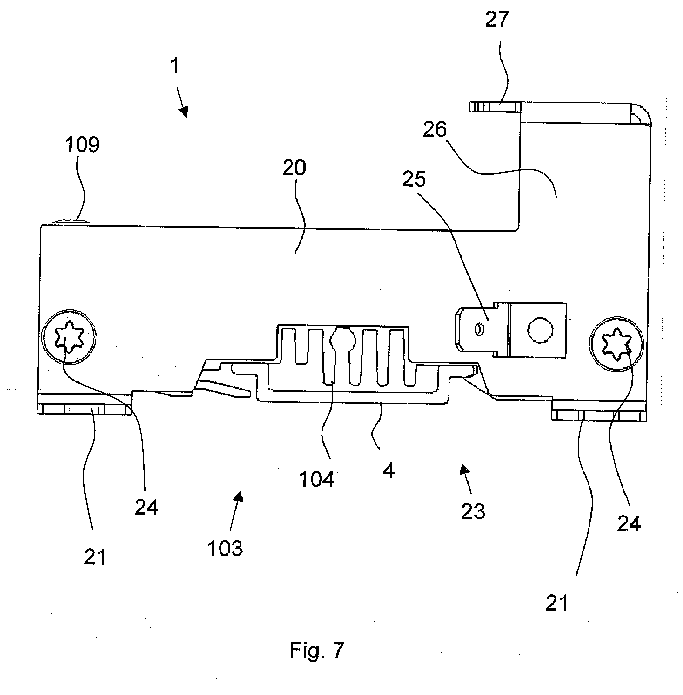

Die vorteilhafte Kontur innerhalb der die Kühlrippen 104 des Gehäusebodens ausgebildet sind wird nachfolgend anhand von Fig. 6 und 7 detailliert beschrieben.

Der Gehäusegrundkörper 10 eines erfindungsgemäßen Gehäuses 1 umfasst außerdem geeignete horizontale Ausnehmungen 108 in den Wänden 101, 102 zur Aufnahme von Befestigungsmitteln 24 zur Befestigung der seitlichen Wände 20, wobei die Befestigungsmittel 24 geeigneterweise ebenfalls Schrauben sein können, die mit den Ausnehmungen 108 und/oder in den Ausnehmungen 108 ausgebildeten Gewindebohrungen korrespondieren.

Fig. 5B zeigt eine vergrößerte Darstellung eines Teilbereichs der schematischen Darstellung von Fig. 5A mit der oberen und unteren Leiterplatte 3, 3' und den jeweiligen Klemmzonen 106, 105; 106', 105' an der Innenseite der Wand 102, wobei vorteilhaft jeweils zusammen mit der Leiterplatte 3, 3' ein Ausgleichselement 31 an wenigstens der Unterseite oder der Oberseite der Leiterplatte 3, 3' vorgesehen ist, wodurch vorteilhaft ein Toleranzausgleich von Toleranzen der Stärke der Leiterplatte 3, 3' bereitgestellt ist und außerdem vorteilhaft eine Dämpfung von Spannungen und ein Klapperschutz bei Erschütterungen des Gehäuses 1 bereitgestellt ist.

Fig. 6 zeigt eine perspektivische Darstellung des erfindungsgemäßen Gehäuses 1 von Fig. 2 zusammen mit einer Hutschiene und Fig. 7 zeigt eine schematische Seitenansicht von Fig. 6, wobei hier der Einfachheit halber auf bereits beschriebene Elemente des erfindungsgemäßen Gehäuses 1 verzichtet wird und stattdessen auf die Beschreibung zu den Figuren 2 bis 5 verwiesen wird.

Zu Fig. 5 wird hier ergänzend erwähnt, dass natürlich auch ein erfindungsgemäßes Gehäuse 1 nach der Ausführung gemäß Fig. 2 mit dem Befestigungsbügel 27 vorteilhaft entsprechende Klemmzonen 105, 106; 105', 106' und die übrigen zu der vorstehenden Beschreibung von Fig. 5 genannten Merkmale umfassen kann.

Geeigneterweise ist die vorteilhafte Kontur 103 des Bodens des Gehäusegrundkörpers 10 derart ausgebildet, dass die Kontur 103 mit einer Hutschiene 4 korrespondiert, und auf einfache Weise zu Aufnahme einer Hutschiene 4 ausgelegt ist, so dass das Gehäuse 1 in eine vorhandenen Hutschiene 4 eingelegt werden kann und auf einfache Weise an den Füßen 20 an einer Montageebene befestigt werden kann.

**BEZUGSZEICHENLISTE**

| | |
|---|---|
| Gehäuse | 1 |
| Gehäusegrundkörper | 10 |
| erste Wand | 101 |
| zweite Wand | 102 |
| Kontur | 103 |
| Kühlrippe | 104 |
| erster Vorsprung | 105, 105' |
| zweiter Vorsprung | 106, 106' |
| Vertikale Ausnehmung | 107 |
| Horizontale Ausnehmung | 108 |
| Befestigungsmittel | 109 |
| Distanzstück | 110 |
| Seitliche Wand | 20 |
| Fuß | 21 |
| Bohrung | 22 |
| Kulisse | 23 |
| Befestigungsmittel | 24 |
| Anschluss | 25 |
| Vorspringender Absatz | 26 |
| Befestigungsbügel | 27 |
| Ausnehmungen | 28 |
| Blende | 29 |
| erste Leiterplatte | 3 |
| zweite Leiterplatte | 3' |
| Anschlußbuchse | 30 |
| Ausgleichselement | 31 |
| Wärmeleitelement | 32 |
| Fenster | 33 |
| Bohrung | 34 |
| Hutschiene | 4 |

## Patentansprüche

1. Gehäuse (1) für wenigstens eine Leiterplatte (3, 3') mit einem länglichen einstückig ausgebildeten U - förmigen Gehäusegrundkörper (10) mit einem Gehäuseboden und einer ersten (101) und zweiten (102) Wand, und mit zwei seitlichen Wänden (20), die an dem Gehäusegrundkörper (10) befestigt sind, wobei:
der Gehäusegrundkörper (10) mit den beiden an ihm befestigten seitlichen Wänden (20) bildet ein nach oben offenes kastenförmiges Gehäuse, das derart ausgebildet ist, dass wenigstens eine Leiterplatte (3, 3') von oben in das Gehäuse (1) einsetzbar und in dem Gehäuse (1) fixierbar ist, wobei die oberste der Leiterplatten (3, 3') mit ihrer bestückten Seite nach unten anzuordnen ist, sodass ihre andere Seite das Gehäuse (1) oben abschließt, und wobei
von ersten (101) und zweiten (102) Wand die zweite Wand (102) eine Klemmzone zur Einführung und Fixierung der Leiterplatten (3, 3') umfasst,
die zweite Wand (102) im Bereich der Klemmzone obere schienenartige Vorsprünge (106, 106') sowie untere schienenartige Vorsprünge (105, 105') umfasst, **dadurch gekennzeichnet, dass**
der Gehäusegrundkörper (10) als Strangpreßprofil bereitgestellt ist,
die unteren schienenartigen Vorsprünge (105, 105') nach oben abgewinkelt ausgebildet sind, und
die Vorsprünge (106, 105, 106', 105') derart angeordnet sind, dass nach dem Einsetzen der Leiterplatte (3, 3') in den zwischen den Vorsprüngen (105, 106, 105', 106') bereitgestellten Raum in einem Winkel von oben und nach Absenken der Leiterplatte (3, 3') in eine waagerechte Position die jeweilige Leiterplatte in dem zwischen den oberen und unteren Vorsprüngen (105, 106, 105', 106') bereitgestellten Raum fixiert ist.

2. Gehäuse (1) nach Anspruch 1, **dadurch gekennzeichnet, dass**
das Gehäuse (1) einen mit den beiden seitlichen Wänden (20) einstückigen Befestigungsbügel (27) umfasst, der sich oberhalb der das Gehäuse (1) oben abschließenden Leiterplatte (3, 3') von einer seitlichen Wand (20) zu der anderen seitlichen Wand (20) erstreckt, und wobei der Befestigungsbügel (27) derart ausgebildet ist, dass Klemmvorrichtungen für mit den Anschlußbuchsen (30) verbundene Kabel für Zugentlastung der Kabel an dem Befestigungsbügel (27) vorsehbar sind.

3. Gehäuse (1) nach Anspruch 2, **dadurch gekennzeichnet, dass** die seitlichen Wände (20) und der Befestigungsbügel (27) aus einem gemeinsamen Metallblech gestanzt sind, wobei an den seitlichen offenen Enden des Gehäusegrundkörpers (10) die beiden seitlichen Wände (20) jeweils um etwa 90° von dem Befestigungsbügel (27) nach unten abgewinkelt sind.

## Claims

1. Housing (1) for at least one printed circuit board (3, 3') having an elongate integrally formed U-shaped housing main body (10) with a housing base and a first wall (101) and a second wall (102), and having two side walls (20) which are fastened to the housing main body (10), wherein:
the housing main body (10) forms, with the two side walls (20) which are fastened to it, a box-like housing which is open at the top and which is designed in such a way that at least one printed circuit board (3, 3') can be inserted into the housing (1) from above and can be fixed in the housing (1), wherein the topmost of the printed circuit boards (3, 3') is to be arranged with its populated side at the bottom, so that its other side closes off the housing (1) at the top, and wherein
from amongst the first wall (101) and the second wall (102), the second wall (102) comprises a clamping zone for inserting and fixing the printed circuit boards (3, 3'),
the second wall (102) comprises, in the region of the clamping zone, upper rail-like projections (106, 106') and lower rail-like projections (105, 105'), **characterized in that**
the housing main body (10) is provided as an extruded profile,
the lower rail-like projections (105, 105') are designed such that they are angled upwards, and
the projections (106, 105, 106', 105') are arranged in such a way that, after insertion of the printed circuit board (3, 3') into the space which is provided between the projections (105, 106, 105', 106') at an angle from above and after lowering of the printed circuit board (3, 3') into a horizontal position, the respective printed circuit board is fixed in the space which is provided between the upper and lower projections (105, 106, 105', 106').

2. Housing (1) according to Claim 1, **characterized in that**
the housing (1) comprises a fastening clip (27) which is integral with the two side walls (20) and which extends from one side wall (20) to the other side wall (20) above the printed circuit board (3, 3') which closes off the housing (1) at the top, and wherein the fastening clip (27) is formed in such a way that clamping apparatuses for cables which are connected to the connection sockets (30) can be provided on the fastening clip (27) for strain relief of the cables.

3. Housing (1) according to Claim 2, **characterized in that** the side walls (20) and the fastening clip (27) are punched from a common metal sheet, wherein the two side walls (20) are each angled downwards from the fastening clip (27) through approximately 90° at the lateral open ends of the housing main body (10).

## Revendications

1. Boîtier (1) pour au moins une carte à circuits imprimés (3, 3') comprenant un corps de base de boîtier (10) allongé en forme de U réalisé d'une seule pièce avec un fond de boîtier et une première (101) et une deuxième (102) paroi, et avec deux parois latérales (20), qui sont fixées au corps de base de boîtier (10), dans lequel :
le corps de base de boîtier (10) forme avec les deux parois latérales (20) fixées sur celui-ci un boîtier en forme de caisson ouvert vers le haut qui est réalisé de telle sorte qu'au moins une carte à circuits imprimés (3, 3') puisse être insérée par le haut dans le boîtier (1) et être fixée dans le boîtier (1), la carte à circuits imprimés (3, 3') la plus supérieure devant être disposée avec son côté garni vers le bas de telle sorte que son autre côté termine le boîtier (1) vers le haut, et dans lequel
parmi la première (101) et la deuxième (102) paroi, la deuxième paroi (102) comprend une zone de serrage pour introduire et fixer les cartes à circuits imprimés (3, 3'),
la deuxième paroi (102) présente, dans la région de la zone de serrage, des saillies supérieures en forme de rails (106, 106') ainsi que des saillies inférieures en forme de rails (105, 105'), **caractérisé en ce que**
le corps de base de boîtier (10) est fourni sous forme de profilé filé,
les saillies inférieures en forme de rail (105, 105') sont réalisées sous forme coudée vers le haut, et
les saillies (106, 105, 106', 105') sont disposées de telle sorte qu'après l'insertion par le haut suivant un certain angle de la carte à circuits imprimés (3, 3') dans l'espace fourni entre les saillies (105, 106, 105', 106') et après l'abaissement de la carte à circuits imprimés (3, 3') dans une position horizontale, la carte à circuits imprimés respective soit fixée dans l'espace fourni entre les saillies supérieures et inférieures (105, 106, 105', 106').

2. Boîtier (1) selon la revendication 1, **caractérisé en ce que**
le boîtier (1) comprend un étrier de fixation (27) réalisé d'une seule pièce avec les deux parois latérales (20), qui s'étend au-dessus de la carte à circuits imprimés (3, 3') terminant le boîtier (1) en haut, depuis une paroi latérale (20) jusqu'à l'autre paroi latérale (20), et l'étrier de fixation (27) étant réalisé de telle sorte que des dispositifs de serrage puissent être prévus au niveau de l'étrier de fixation (27) pour des câbles connectés aux douilles de raccordement (30) en vue de la détente de traction des câbles.

3. Boîtier (1) selon la revendication 2, **caractérisé en ce que** les parois latérales (20) et l'étrier de fixation (27) sont estampés dans une tôle métallique commune, les deux parois latérales (20) étant à chaque fois coudées vers le bas d'environ 90° à partir de l'étrier de fixation (27) aux extrémités latérales ouvertes du corps de base de boîtier (10).
